Europäisches Patentamt

European Patent Office

Office européen des brevets

(19)

(11) Veröffentlichungsnummer: **0 337 266**
**A2**

(12) **EUROPÄISCHE PATENTANMELDUNG**

(21) Anmeldenummer: 89105930.5

(22) Anmeldetag: 05.04.89

(51) Int. Cl.⁴: **G08C 19/02 , G01R 15/02 , H01B 17/00**

(30) Priorität: **12.04.88 DE 3812054**

(43) Veröffentlichungstag der Anmeldung:
**18.10.89 Patentblatt 89/42**

(84) Benannte Vertragsstaaten:
**AT BE CH DE LI NL**

(71) Anmelder: **MASCHINENFABRIK REINHAUSEN GMBH**
**Falkensteinstrasse 8**
**D-8400 Regensburg(DE)**

(72) Erfinder: **Kugler, Kurt, Dipl. Ing. (FH)**
**Hainsacker Kellerweg 12**
**D-8417 Lappersdorf(DE)**

(54) **Verfahren zur Messwertübertragung zwischen einem Koppelstützisolator und einem Auswertegerät.**

(57) Verfahren zur Meßwertübertragung zwischen einem Koppelstützisolator mit integriertem von einer äußeren Gleichspannungsquelle versorgten Meßverstärker und einem Auswertegerät. Hierbei wird mittels einer Zweidrahtleitung, die der Stromversorgung des Meßverstärkers dient, vom Meßverstärker als Meßsignal ein eingeprägter der Überwachung des Meßverstärkers dienender Gleichstrom mit einem Wechselstromanteil, der sich aus Phasenlage und Höhe der zu messenden Hochspannung bestimmt, an das Auswertegerät übertragen. Das übertragene Meßsignal wird mittels eines Isolierverstärkers im Auswertegerät von der weiteren Verarbeitung galvanisch getrennt.

EP 0 337 266 A2

**Verfahren zur Meßwertübertragung zwischen einem Koppelstützisolator und einem Auswertegerät**

Die Erfindung bezieht sich auf ein Verfahren gemäß Oberbegriff des Patentanspruches.

Es ist bekannt, für Meßzwecke in der Elektrotechnik sogenannte Koppelstützisolatoren einzusetzen. Ein Koppelstützisolator arbeitet hierbei wie ein kapazitiver Meßteiler mit nachfolgendem elektronischen Verstärker, wobei die Ausgangsspannung des Verstärkers direkt für Meßzwecke verwendet werden kann Meßteiler und Verstärker sind dabei im Stützisolator integriert (DE 31 21 795 A1). Allerdings läßt sich die vom Meßverstärker abgegebene Ausgangsspannung im allgemeinen nicht direkt am Koppelstützisolator verwerten. Ferner ist zu berücksichtigen, daß der Koppelstützisolator praktisch nicht zugänglich ist. Es stellt sich deshalb die Aufgabe, die vom Meßverstärker des Stützisolators abgegebenen Signale einem Auswertegerät zuzuführen, wobei das ordnungsgemäße Arbeiten des Meßverstärkers sichergestellt bzw. überwacht werden muß.

Aufgabe der Erfindung ist es somit, ein mit einfachen Mitteln durchführbares Verfahren zur Meßwertübertragung zwischen einem Koppelstützisolator mit integriertem von einer äußeren Gleichspannungsquelle versorgtem Meßverstärker und einem Auswertegerät anzugeben, das neben der eigentlichen Meßwertübertragung gleichzeitig eine Funktionsüberwachung des Meßverstärkers ermöglicht. Diese Aufgabe wird erfindungsgemäß durch das im Patentanspruch angegebene Verfahren gelöst

Das erfindungsgemäße Verfahren kommt für die eigentliche Übertragung der Meßwerte mit einer Zweidrahtleitung aus, die auch der Gleichspannungsversorgung des Meßverstärkers dient. Die Überwachung des Meßverstärkers erfolgt hierbei, indem als Meßsignal ein vom Meßverstärker gelieferter eingeprägter Gleichstrom verwendet wird, dem ein Wechselstromanteil, der sich aus Phasenlage und Höhe der zu messenden Hochspannung bestimmt, überlagert ist. Somit können ein Ausfall des im Stützisolator sitzenden elektronischen Meßverstärkers oder eine Störung in der Meßleitung sofort registriert werden. Eine Potentialtrennung zwischen gelieferten Meßsignalen und weiterer Verarbeitung läßt sich ohne weiteres durch ein im Auswertegerät angeordneten Isolierverstärker vornehmen.

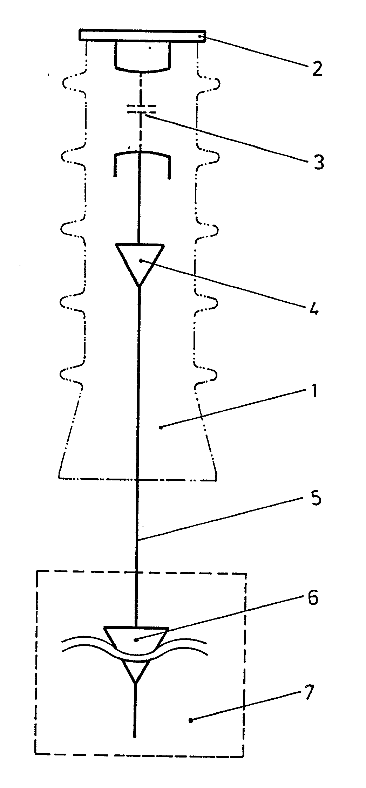

Die Zeichnung verdeutlicht schematisch bzw. schaltbildmäßig eine Anordnung zur Durchführung des Verfahrens. Hierbei ist der Stützisolator 1, der die Sammelschiene 2 trägt, als Stützisolator mit kapazitivem Spannungsteiler 3 ausgeführt. Er enthält einen Meßverstärker 4, der über eine Zweidrahtleitung 5 die Meßsignale mit dem eingeprägten Gleichstrom an den Isolierverstärker 6 in dem Auswertegerät 7 liefert.

**Ansprüche**

Verfahren zur Meßwertübertragung zwischen einem Koppelstützisolator mit integriertem von einer äußeren Gleichspannungsquelle versorgten Meßverstärker und einem Auswertegerät, dadurch gekennzeichnet, daß mittels der der Stromversorgung des Meßverstärkers dienenden Zweidrahtleitung vom Meßverstärker als Meßsignal ein eingeprägter der Überwachung des Meßverstärkers dienender Gleichstrom mit einem Wechselstromanteil, der sich aus Phasenlage und Höhe der zu messenden Hochspannung bestimmt, an das Auswertegerät übertragen wird, wobei das Meßsignal mittels eines Isolierverstärkers im Auswertegerät von der weiteren Verarbeitung galvanisch getrennt wird.